# EUROPEAN PATENT APPLICATION

(11) **EP 1 973 152 A1**
(43) Date of publication of application: **24.09.2008**
(21) Application number: 06832964.8
(22) Date of filing: 20.11.2006
(51) Int. Cl.: H01L 21/304

(54) **SUBSTRATE CLEANING APPARATUS, METHOD OF SUBSTRATE CLEANING, SUBSTRATE TREATING SYSTEM AND RECORDING MEDIUM**

(30) Priority: 10.01.2006 JP 2006002234
(71) Applicant: TOKYO ELECTRON LIMITED, Minato-ku Tokyo 107-8481 (JP)
(72) Inventor: MATSUMOTO, Kazuhisa, Koshi-shi Kumamoto 861-1116 (JP)
(74) Representative: HOFFMANN EITLE
(86) International application number: PCT/JP2006/323114
(87) International publication number: WO 2007/080707

(57) **Abstract**

A substrate cleaning apparatus 40 includes: a cleaning tank 70; a holding table 51 rotatably disposed in the cleaning tank 70, for holding a substrate to be processed W; and a rotary drive mechanism 52 for rotating the holding table 51. A chemical liquid storing unit 53 is disposed at a part circumferentially outward of the holding table 51, for storing a chemical liquid along a peripheral part of the substrate to be processed W held by the holding table 51, so as to immerse the peripheral part of the substrate to be processed W in the chemical liquid. A chemical liquid supply unit 54 is connected to the chemical liquid storing unit 53, for supplying a chemical liquid to the chemical liquid storing unit 53. Further, there is disposed a brush 55d for brushing the peripheral part of the substrate to be processed held by the holding table 51.

## Description

### FIELD OF THE INVENTION

The present invention relates to: a substrate cleaning apparatus for cleaning a substrate to be processed, such as a semiconductor wafer; a substrate cleaning method thereof; a substrate processing system including the substrate cleaning apparatus; and a storage medium for use in the substrate cleaning apparatus. In particular, the present invention pertains to: a substrate cleaning apparatus capable of removing a contamination remaining on a peripheral part of a substrate to be processed; a substrate cleaning method thereof, a substrate processing system including the substrate cleaning apparatus; and a storage medium for use in the substrate cleaning apparatus.

### BACKGROUND ART

In a manufacturing process of a semiconductor device, a substrate cleaning apparatus is generally used for removing contaminations, such as resists, particles, inorganic contaminations, and metal impurities, which adheres to a substrate to be processed, such as a semiconductor wafer and a glass substrate for an LCD (hereinafter referred to as "wafer"). As one of the substrate cleaning apparatuses, a substrate cleaning apparatus of a spin type has been known, for example.

In the conventional spin-type substrate cleaning apparatus, a wafer is held by a spin chuck as holding means disposed in a cleaning tank. While the spin chuck is being rotated at a low speed, a chemical liquid and a pure water are sequentially supplied onto a surface of the wafer to perform a chemical liquid process and a rinsing process, and thereafter the spin chuck is rotated at a high speed to perform a drying process (see, for example, JP2001-160546A).

In addition, in order to clean a peripheral part (edge part) of the wafer, there has been known a method of brushing the peripheral part of the wafer by a rotating brush, while a process liquid such as a cleaning water is being supplied to the peripheral part of the rotating wafer (see, for example, JP6-45302A).

However, even when a surface of a wafer is subjected to the chemical liquid process described in JP2001-160546A, there is a possibility that a peripheral part of the wafer cannot be thoroughly cleaned. Namely, when the wafer is subjected to an etching process before the wafer is sent to a substrate cleaning apparatus, a contamination such as a CFx polymer or the like adheres to a surface of the wafer by the etching process. In this case, the contamination adhering to the peripheral part of the wafer cannot be perfectly removed by means of a chemical liquid sent to a central part of the surface of the wafer in the above-described chemical liquid process.

Further, the contamination such as a CFx polymer or the like, which has adhered to a surface of a wafer by an etching process, sticks fast to a peripheral part of the wafer. Thus, even when the method described in JP6-45302A is used to brush the peripheral part of the wafer by means of a rotating brush or the like, it is not easy to peel the contamination from the peripheral part of the wafer.

### SUMMARY OF THE INVENTION

The present invention has been made in view of the above points. The object of the present invention is to provide a substrate cleaning apparatus capable of removing a contamination adhering to a peripheral part of a substrate to be processed, a substrate cleaning method thereof, a substrate processing system, and a storage medium.

The present invention is a substrate cleaning apparatus comprising: a cleaning tank; a holding table rotatably disposed in the cleaning tank, for holding a substrate to be processed; a rotary drive unit for rotating the holding table; a chemical liquid storing unit for storing a chemical liquid along a peripheral part of a substrate to be processed held by the holding table to immerse the peripheral part of the substrate to be processed in the chemical liquid; a chemical liquid supply unit connected to the chemical liquid storing unit, for supplying the chemical liquid to the chemical liquid storing unit; and a brush for brushing the peripheral part of the substrate to be processed held by the holding table.
According to the substrate cleaning apparatus, by storing a chemical liquid in the chemical liquid storing unit, the peripheral part of the substrate to be processed can be immersed in the chemical liquid for a long period of time, which weakens an adhering force of a contamination, which adheres to the peripheral part of the substrate to be processed, relative to the substrate to be processed. Since the contamination having the weakened adhering force relative to the wafer is brushed by the brush, the contamination adhering to the peripheral part of the substrate to be processed can be removed.

In the substrate cleaning apparatus of the present invention, it is preferable that the chemical liquid supplied from the chemical liquid supply unit to the chemical liquid storing unit is a hydrofluoric acid.
According to the substrate cleaning apparatus, the contamination adhering to the peripheral part of the substrate to be processed is immersed in the hydrofluoric acid. Thus, the adhering force of the contamination relative to the substrate to be processed can be further weakened, whereby the contamination adhering to the peripheral part of the substrate to be processed can be removed.

In the substrate cleaning apparatus of the present invention, it is preferable that the brush brushes the peripheral part of the substrate to be processed, when a chemical liquid is supplied from the chemical liquid supply unit to the chemical liquid storing unit and the peripheral part of the substrate to be processed is immersed in the chemical liquid stored in the chemical liquid storing unit.
According to the substrate cleaning apparatus, the operation for immersing in the chemical liquid the contamination adhering to the peripheral part of the substrate to be processed, and the operation for removing the contamination by the brush, are simultaneously performed. Thus, the contamination having the adhering force weakened by the chemical liquid can be immediately removed, whereby the contamination adhering to the peripheral part of the substrate to be processed can be removed.

In the substrate cleaning apparatus of the present invention, it is preferable that the brush is capable of reciprocately moving between a contact position in which the brush is in contact with the peripheral part of the substrate to be processed held by the holding table, and a retracted position in which the brush is spaced aunit from the peripheral part, and
the peripheral part of the substrate to be processed rotated by the rotary drive unit is brushed by the brush, when the brush is in the contact position.
According to the substrate cleaning apparatus, whether to brush the peripheral part of the substrate to be processed by the brush or not can be selected corresponding to process conditions of the substrate to be processed. The peripheral part of the substrate to be processed can be brushed by the brush only when needed.

In the substrate cleaning apparatus of the present invention, it is preferable that a first nozzle is disposed above the chemical liquid storing unit, for discharging a gas onto the peripheral part in an upper surface of the substrate to be processed held by the holding table so as to form an airflow flowing radially outward on the upper surface of the substrate to be processed.
According to the substrate cleaning apparatus, by discharging a gas toward the peripheral part of the substrate to be processed from the first nozzle, the chemical liquid stored in the chemical liquid storing unit can be prevented from flowing radially inward on the upper surface of the substrate to be processed.

In the substrate cleaning apparatus of the present invention, it is preferable that the first nozzle is capable of further supplying water onto the peripheral part of the substrate to be processed held by the holding table.
According to the substrate cleaning apparatus, in the rinsing step of the substrate to be processed, water can be sufficiently supplied onto the peripheral part of the substrate to be processed.

In the substrate cleaning apparatus of the present invention, it is preferable that the first nozzle is capable of further supplying a chemical liquid onto the peripheral surface of the substrate to be processed held by the holding table.
According to the substrate cleaning apparatus, since the chemical liquid can be further supplied to the peripheral part in the upper surface of the substrate to be processed, the contamination adhering to the peripheral part of the substrate to be processed can be removed.

In the substrate cleaning apparatus of the present invention, it is preferable that a second nozzle is disposed on a rear surface side of the substrate to be processed held by the holding table, for supplying water onto a part near the peripheral part of the substrate to be processed.
According to the substrate cleaning apparatus, in the rinsing step of the substrate to be processed, water can be sufficiently supplied onto the rear surface of the substrate to be processed.

In the substrate cleaning apparatus of the present invention, it is preferable that the chemical liquid storing unit is formed into an annular shape excluding a cutout region to surround the peripheral part of the substrate to be processed, and the brush is disposed in the cutout region of the chemical liquid storing unit.
According to the substrate cleaning apparatus, the chemical liquid storing unit can surround a larger part of the peripheral part of the substrate to be processed, without interfering with the brush. Thus, the time period when the substrate to be processed is immersed in the chemical liquid can be elongated, while the substrate to be processed is rotated.

The present invention is a substrate processing system comprising: the substrate cleaning apparatus according to claim 1; and an etching apparatus connected to the substrate cleaning apparatus, for etching a substrate to be processed.

The present invention is a substrate cleaning method comprising the steps of: holding a substrate to be processed by a holding table; rotating the holding table; storing a chemical liquid in a chemical liquid storing unit and immersing a peripheral part of the substrate to be processed in the chemical liquid; and brushing the peripheral part of the substrate to be processed by a brush.
According to the substrate cleaning method, the peripheral part of the substrate to be processed is immersed in the chemical liquid stored in the chemical liquid storing unit for a long period of time, which weakens the adhering force of the contamination adhering to the peripheral part of the substrate to be processed relative to the substrate to be processed. Since the contamination having the weakened adhering force relative to the wafer is brushed by the brush, the contamination adhering to the peripheral part of the substrate to be processed can be removed.

In the substrate cleaning method, it is preferable that the brush brushes the peripheral part of the substrate to be processed, when the peripheral part of the substrate to be processed is immersed in the chemical liquid stored in the chemical liquid storing unit.

In order to solve the above problem, there may be used a program that is executable by a control computer of a substrate cleaning apparatus, the storage medium controlling a substrate cleaning apparatus to perform a substrate cleaning method upon execution of the program, the substrate cleaning method comprising the steps of: holding a substrate to be processed by a holding table; rotating the holding table; storing a chemical liquid in a chemical liquid storing unit and immersing a peripheral part of the substrate to be processed in the chemical liquid; and brushing the peripheral part of the substrate to be processed by a brush.

In this program, it is preferable that the step of brushing the peripheral part of the substrate to be processed by the brush is performed, when the peripheral part of the substrate to be processed is immersed in the chemical liquid stored in the chemical liquid storing unit.

The present invention is a storage medium storing a program that is executable by a control computer of a substrate cleaning apparatus, the storage medium controlling a substrate cleaning apparatus to perform a substrate cleaning method upon execution of the program, the substrate cleaning method comprising the steps of: holding a substrate to be processed by a holding table; rotating the holding table; storing a chemical liquid in a chemical liquid storing unit and immersing a peripheral part of the substrate to be processed in the chemical liquid; and brushing the peripheral part of the substrate to be processed by a brush.

In the storage medium, it is preferable that the step of brushing the peripheral part of the substrate to be processed by a brush is performed when the peripheral part of the substrate to be processed is immersed in the chemical liquid stored in the chemical liquid storing unit.

### BRIEF DESCRIPTION OF THE DRAWINGS

An embodiment of the present invention is described below with reference to the accompanying drawings.
Fig. 1 is a schematic sectional view of a structure of a substrate cleaning apparatus of the present invention;
Fig. 2 is a longitudinal sectional view taken along the arrow A-A of the substrate cleaning apparatus shown in Fig. 1;
Fig. 3 is a longitudinal sectional view taken along the arrow B-B of the substrate cleaning apparatus shown in Fig. 1;
Fig. 4 is a longitudinal sectional view taken along the arrow C-C of the substrate cleaning apparatus shown in Fig. 1;
Fig. 5 is an enlarged view of a region D of the substrate cleaning apparatus shown in Fig. 2;
Fig. 6 is a longitudinal sectional view of the substrate cleaning apparatus shown in Fig. 2 in which a wafer is not yet loaded into a cleaning tank;
Fig. 7 is a schematic top view of structure of a substrate processing system;
Fig. 8 is a schematic side view of the substrate processing system shown in Fig. 7,
Fig. 9 is an illustrational block diagram for illustrating an outline of a control computer to be connected to the substrate cleaning apparatus shown in Fig. 1; and
Fig. 10 is an illustrational view of details of a structure of a brushing mechanism of the substrate cleaning apparatus shown in Fig. 4.

### DETAILED DESCRIPTION OF THE INVENTION

The embodiment shown below illustrates by way of example a substrate cleaning apparatus of the present invention which is used as a cleaning unit for subjecting a substrate to be processed, such as a semiconductor wafer, having substantially a discoid contour, to a chemical liquid process, a rinsing process, and a drying process. Along with an etching apparatus, the substrate cleaning apparatus of the present invention is incorporated in a substrate processing system. However, it goes without saying that the substrate cleaning apparatus and a substrate cleaning method of the present invention are not limited to this application.

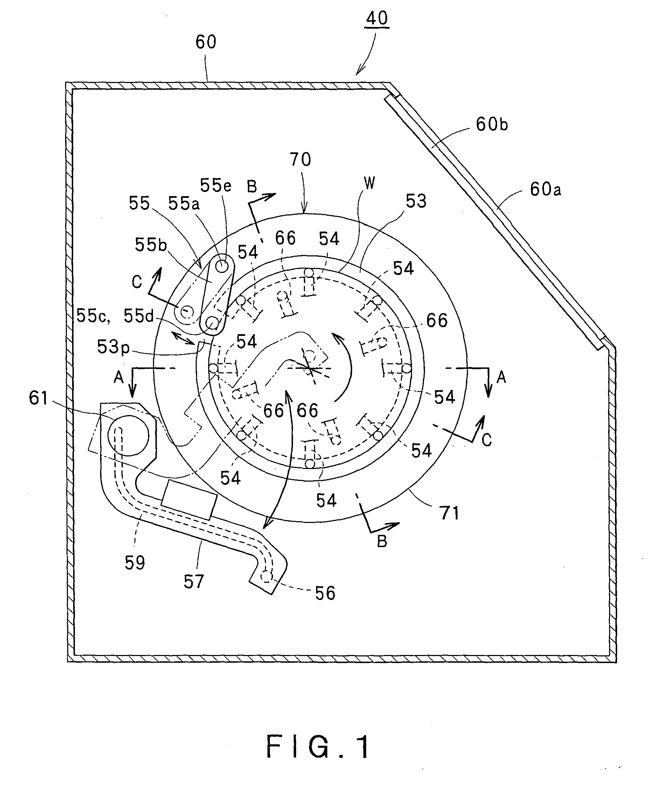

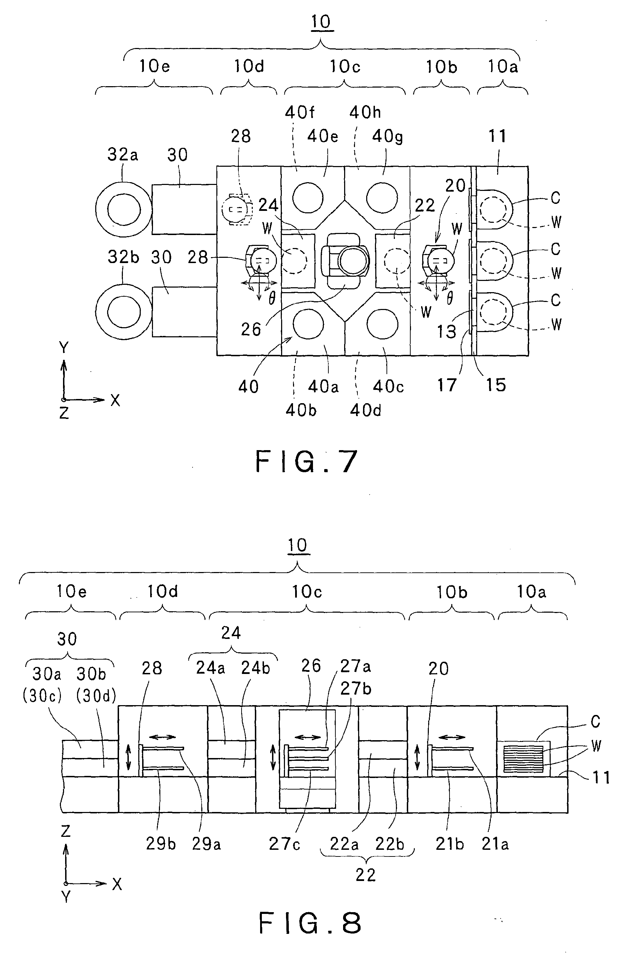

Figs. 1 to 10 respectively show a substrate cleaning apparatus 40 of the present invention. In the first place, an overall structure of a substrate processing system incorporating the substrate cleaning apparatus 40 and a processing method carried out by the same are described. Fig. 7 is a schematic top view of a structure of a substrate processing system 10, and Fig. 8 is a schematic side view of the substrate processing system 10 shown in Fig. 7.

As shown in Figs. 7 and 8, the substrate processing system 10 includes a placing part 10a in which an unprocessed semiconductor wafer W (hereinafter referred to as "wafer W") and a processed wafer W are placed, and a processing part 10e in which a wafer W is subjected to an etching process or the like. Between the placing part 10a and the processing part 10e, there is disposed a cleaning part 10c in which a wafer W, which has been subjected to a process in the processing part 10e, is cleaned. Between the placing part 10a and the cleaning part 10c, there is arranged a first transfer part 10b in which a wafer W is conveyed between the placing part 10a and the cleaning part 10c. Similarly, between the cleaning part 10c and the processing part 10e, there is arranged a second transfer part 10d in which a wafer W is conveyed between the cleaning part 10c and the processing part 10e.
The respective constituent elements of the substrate processing system 10 are described in detail below.

At first, the placing part 10a is described. In the placing part 10a, the substrate processing system 10 has a stage 11. A carrier C for containing a wafer W to be etched and the like is detachably attached to the stage 11.
As shown in Figs. 7 and 8, in this embodiment, three carriers C are placed on the stage 11. Each carrier C is provided with a lid member 13. By opening the lid member 13, a wafer W can be housed in the carrier C. Each carrier C can contain a plurality of, to be specific, e.g., 25 unprocessed wafers W with a predetermined interval therebetween. In this embodiment, a wafer W is substantially horizontally contained in the carrier C with its front surface (surface to be processed on which a semiconductor device is formed) facing upward.

Next, the first transfer part 10b is described. As shown in Fig. 8, the first transfer part 10b has a space defined by a separation wall. A first wafer transfer apparatus 20 is disposed in this space, for conveying a wafer W between the first wafer transfer apparatus 20 and the carrier C, and between the first wafer transfer apparatus 20 and a conveying unit 22 (described below) of the cleaning part 10c. As shown in Fig. 7, windows (openings) are formed in a separation wall 15 disposed between the placing part 10a and the first transfer part 10b. There are provided window opening/closing mechanisms 17 such as shutters for opening and closing the windows. When the carrier C is attached to the stage 11, the lid member 13 of the carrier C is configured to be positioned near the window in the separation wall 15. It is preferable that, when the window opening/closing mechanism 17 opens/closes the window, the lid member 13 of the carrier C is simultaneously opened/closed.

As shown in Fig. 7, the first wafer transfer apparatus 20 is movable in an X direction and a Y direction (both horizontal directions), so that the first wafer transfer apparatus 20 can access the carrier C and the conveying unit 22 (described below) of the cleaning part 10c. As shown in Fig. 8, the first wafer transfer apparatus 20 has two wafer holding arms 21a and 21b each for holding a wafer W. These two wafer holding arms 21a and 21b are spaced apart from each other in a height direction. The wafer holding arms 21a and 21b are rotatable in an X-Y plane as a horizontal plane (θ direction in Fig. 7), movable in a Z direction (vertical direction), and independently movable in forward and rearward directions. When the first wafer transfer apparatus 20 is moved, and the wafer holding arms 21a and 21b are rotated, vertically moved, and moved forward and rearward, a wafer W held on each of the wafer holding arms 21a and 21b can be brought into the carrier C or the conveying unit 22. In the first transfer apparatus 20, a wafer W can be brought out from the carrier C or the conveying unit 22 onto the wafer holding arms 21a and 21b.

Next, the cleaning part 10c is described. As shown in Fig. 8, the cleaning part 10c has a space defined by a separation wall. As shown in Fig. 7, in the space defined by the separation wall, the substrate processing system 10 has the first conveying unit 22 which is connected to the first transfer part 10b, a second conveying unit 24 which is connected to the second transfer part 10d, a substrate cleaning apparatus (wafer cleaning unit) 40, and a main wafer transfer apparatus 26 for transferring a wafer W in the cleaning part 10c.

The main wafer transfer apparatus 26 is movable in the X direction and the Y direction, so that the main wafer transfer apparatus 26 can access the respective units 22, 24, and 40. As shown in Fig. 8, the main wafer transfer apparatus 26 has three wafer holding arms 27a, 27b, and 27c each for holding a wafer W. These three wafer holding arms 27a, 27b, and 27c are spaced apart from each other in the height direction. The wafer holding arms 27a, 27b, and 27c are rotatable in the X-Y plane as a horizontal plane (θ direction in Fig. 7), movable in the Z direction (vertical direction), and independently movable in the forward and rearward directions. On the other hand, each of the units 22, 24, and 40 is provided with an openable/ closable window (not shown) for receiving a wafer W. When the main wafer transfer apparatus 26 is moved, and the wafer holding arms 27a, 27b, and 27c are rotated, vertically moved, and moved forward and rearward, a wafer W held on each of the wafer holding arms 27a, 27b, and 27c can be brought into the respective units 22, 24, and 40. A wafer W can be brought out from the respective units 22, 24, 40 onto the wafer holding arms 27a, 27b, and 27c.

As shown in Fig. 8, the cleaning part 10c of the substrate processing system 10 has two first conveying units 22a and 22b which are vertically stacked on each other. Windows (not shown) capable of being opened and closed are formed in the first conveying units 22a and 22b on a side of the first transfer part 10b. Namely, the cleaning part 10c and the first transfer part 10b are communicated with each other through these windows. In addition, through these windows, a wafer W held on each of the wafer holding arms 21a and 21b can be brought into the first conveying unit 22, or a wafer W can be brought out from the conveying unit 22 onto each of the wafer holding arms 21a and 21b.

The second transfer unit 24 is of substantially the same structure as that of the first transfer unit 22. That is, as shown in Fig. 8, the cleaning part 10c of the substrate processing system 10 has two second transfer units 24a and 24b which are stacked on each other in the vertical direction. Windows (not shown) capable of being opened and closed are formed in the second conveying units 24a and 24b on a side of the second transfer part 10d. Namely, the cleaning part 10c and the second transfer part 10d are communicated with each other through these windows. In addition, through these windows, a wafer W can be conveyed between the second conveying unit 24 and a second wafer transfer apparatus 28 (described below).
In this embodiment, in the cleaning part 10c, there are disposed four pairs of vertically stacked substrate cleaning apparatuses (wafer cleaning units), i.e., a total of eight substrate cleaning apparatuses (wafer cleaning units) 40a to 40h.

Next, the second transfer part 10d is described the second transfer part 10d is of substantially the same structure as that of the first transfer part 10b. Specifically, as shown in Fig. 8, the second transfer part 10d has a space defined by a separation wall. The second wafer transfer apparatus 28 is disposed in this space. The second wafer transfer apparatus 28 conveys a wafer W between the same and the second conveying unit 24 of the cleaning part 10c, and between the same and the below-described third conveying unit 30 of the processing part 10e. As indicated by the arrow in Fig. 7, the second wafer transfer apparatus 28 is movable in the X direction and the Y direction, so that the second wafer transfer apparatus 28 can access the second conveying unit 24 and the below-described processing part 10e. As shown in Fig. 8, the second wafer transfer apparatus 28 has two wafer holding arms 29a and 29b each for holding a wafer W. These two wafer holding arms 29a and 29b are spaced apart from each other in the height direction. The wafer holding arms 29a and 29b are rotatable in the X-Y plane as a horizontal plane (θ direction in Fig. 7), movable in the Z direction (vertical direction), and independently movable in the forward and rearward directions. When the second wafer transfer apparatus 28 is moved, and the wafer holding arms 29a and 29b are rotated, vertically moved, and moved forward and rearward, a wafer W held on each of the wafer holding arms 29a and 29b can be brought into the second conveying unit 24 or the below-described third conveying unit 30. A wafer W can be brought out from the second conveying unit 24 or the third conveying unit 30 onto each of the wafer holding arms 29a and 29b.

Next, the processing part 10e is described. As shown in Fig. 7, in the processing part 10e, two etching apparatuses 32a and 32b for etching a wafer W are spaced apart from each other in the Y direction. Between each of the etching apparatuses 32a and 32b and the second transfer part 10d, there are disposed two vertically stacked third conveying units, i.e., a total of four third conveying units 30a, 30b, 30c, and 30d (see, Figs. 7 and 8). Windows (not shown) capable of being opened and closed are formed in the respective third conveying units 30a, 30b, 30c, and 30d on a side of the second transfer part 10d. The processing part 10e and the second transfer part 10d are communicated with each other through these windows. In addition, through these windows, a wafer W held on the wafer holding arms 29a and 29b can be brought into the third conveying unit 30, or a wafer W can be brought out from the third conveying unit 30 onto each of the wafer holding arms 29a and 29b. Similarly, windows (not shown) capable of being opened and closed are formed in the respective third conveying units 30a, 30b, 30c, and 30d on a side of the etching apparatus 32, and windows (not shown) are formed in the etching apparatuses 32 on a side of the third conveying units 30. Thus, through these windows, a wafer W can be conveyed between the etching apparatuses 32 and the third conveying units 30.

Next, an overall processing method of a wafer W performed by the substrate processing system 10 is described.

At first, the carrier C containing a plurality of, e.g., 25 wafers W to be processed is attached to the stage 11. Then, the window opening/closing mechanism 17 and the lid member 13 of the carrier C are opened. The first wafer transfer apparatus 20 comes close to the carrier C and enters the same. For example, the lower wafer holding arm 21b of the first wafer transfer apparatus 20 takes out one of the wafers W from the carrier C through the window. Thereafter, the wafer holding arm 21b is retracted and rotated, and the first wafer transfer mechanism 20 is moved, so that the wafer W taken out from the carrier C is transferred to the lower first conveying unit 22b.

Then, the wafer W placed in the lower first conveying unit 22b is received by the main wafer transfer apparatus 26, and is transferred to the second conveying unit 24b. More specifically, the wafer W is held by, for example, the lower wafer holding arm 27c of the main wafer transfer apparatus 26 and is brought into the lower second conveying unit 24b.

After that, the wafer W placed in the lower second conveying unit 24b is received by the second wafer transfer apparatus 28, and is transferred to the third conveying unit 30. More specifically, the wafer W is held by, for example, the lower wafer holding arm 29b of the second wafer transfer apparatus 28 and is brought into either one of the lower third conveying unit 30b or 30d.

Then, the wafer W placed in either one of the lower third conveying unit 30b or 30d is brought into the corresponding etching apparatus 32 where the wafer W is subjected to an etching process.

The wafer W which has been etched is brought again to the third conveying unit 30. To be specific, the wafer W is carried to the third conveying unit which is not the third conveying unit used when the wafer W is loaded into the etching apparatus 32, i.e., either one of the upper third conveying unit 30a or 30c.

Thereafter, the wafer W which has been sent to either one of the upper third conveying unit 30a or 30c is received by the second wafer transfer apparatus 28, and is transferred to the second conveying unit 24. To be specific, the wafer W is held on the upper wafer holding arm 29a of the second wafer transfer apparatus 28, and is brought into the upper second conveying unit 24a.

Then, the wafer W which has been sent into the upper second conveying unit 24a is received by the main wafer transfer apparatus 26, and is brought into any one of the substrate cleaning apparatuses 40. The wafer W is subjected to a cleaning process, which will be described in detail below, by the substrate cleaning apparatus 40. Specifically, the wafer W is held by, for example, the intermediate wafer holding arm 27b of the main wafer transfer apparatus 26, and is sent into the substrate cleaning apparatus 40 by the wafer holding arm 27b.
The cleaned and dried wafer W is again received by the main wafer transfer apparatus 26, and is brought into the first conveying unit 22. In this case, the wafer W is held by, for example, the upper wafer holding arm 27a of the main wafer transfer apparatus 26, and is brought into the upper first conveying unit 22.

Following thereto, the wafer W which has been sent into the upper first conveying unit 22a is received by the first wafer transfer apparatus 20, and is again contained in the carrier C. At this time, the wafer W is held by, for example, the upper wafer holding arm 21a of the first wafer transfer apparatus 20. In this manner, a series of processes to one wafer W is completed.

In the above process, when the wafer W is unloaded from the respective units or is loaded thereinto, the windows in the respective units are naturally opened, and the windows are closed otherwise. The above transfer operation of the wafer W from the carrier C is serially performed. Thus, wafers W are sequentially brought into the vacant etching apparatus 32 to be sequentially etched, and the wafers W are sequentially brought into the vacant substrate cleaning apparatus 40 to be cleaned and dried. The respective wafer transfer apparatuses 20, 26, and 28 have the plurality of wafer holding arms, and the respective conveying units 22, 24, and 30 are vertically stacked. Such a structure is preferred in terms of production efficiency, since the wafers W can be conveyed simultaneously in the reverse directions. In addition, since an opening period of the window in each unit can be reduced, such a structure is advantageous in maintaining cleanliness of an inside of each unit.

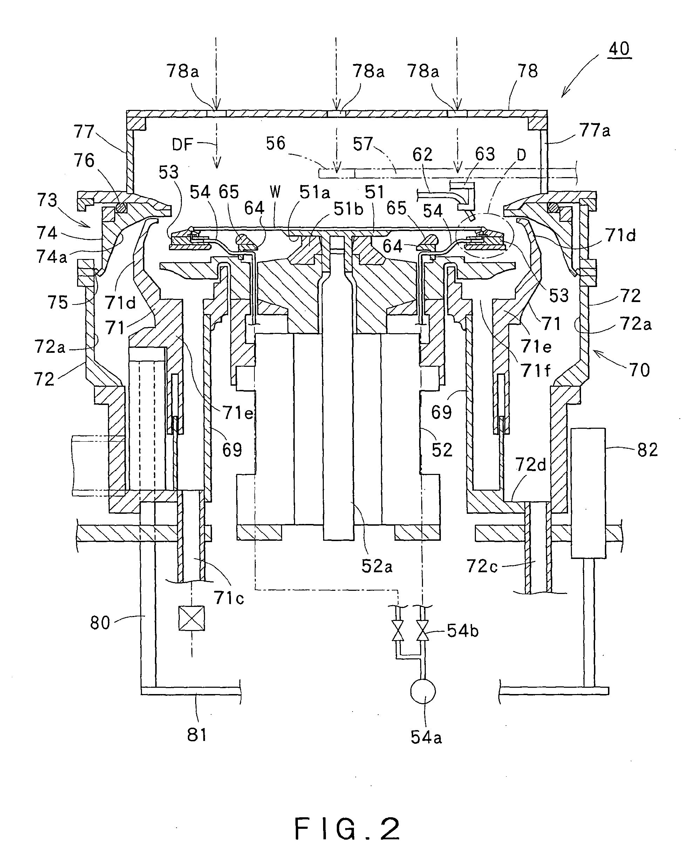

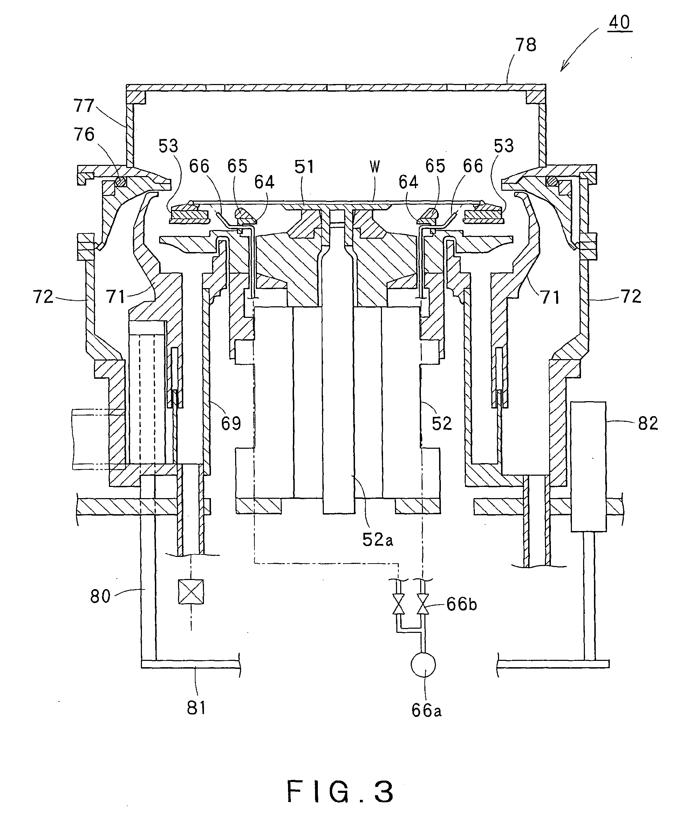

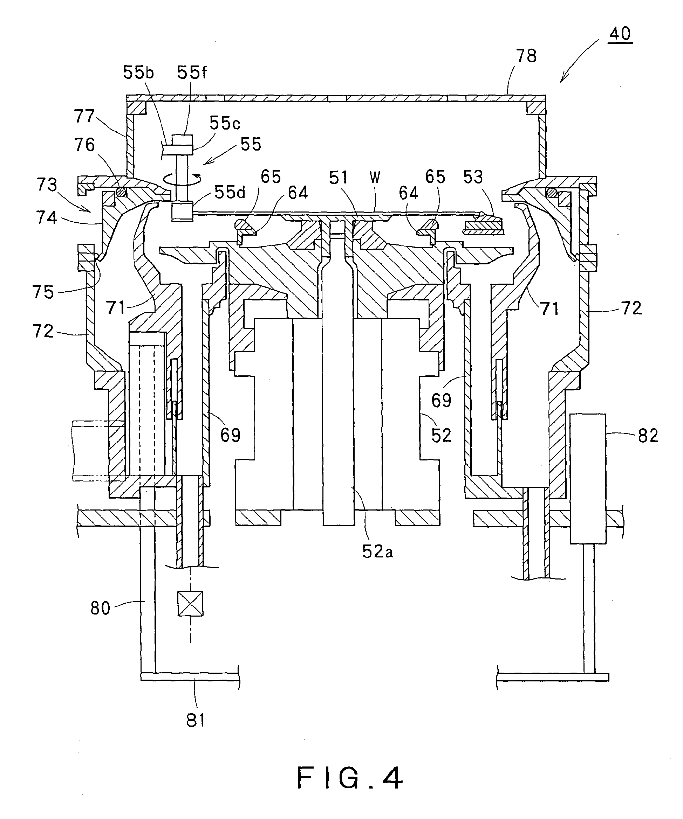

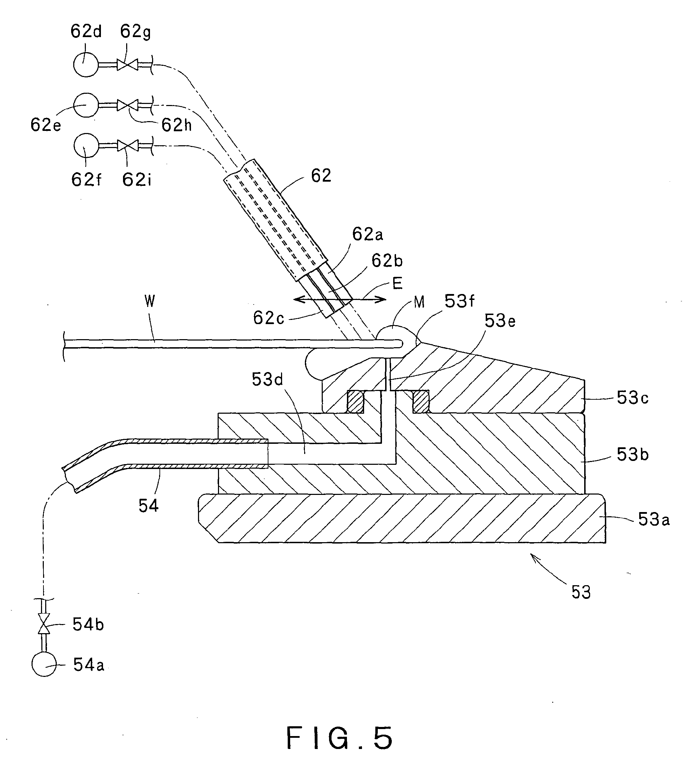

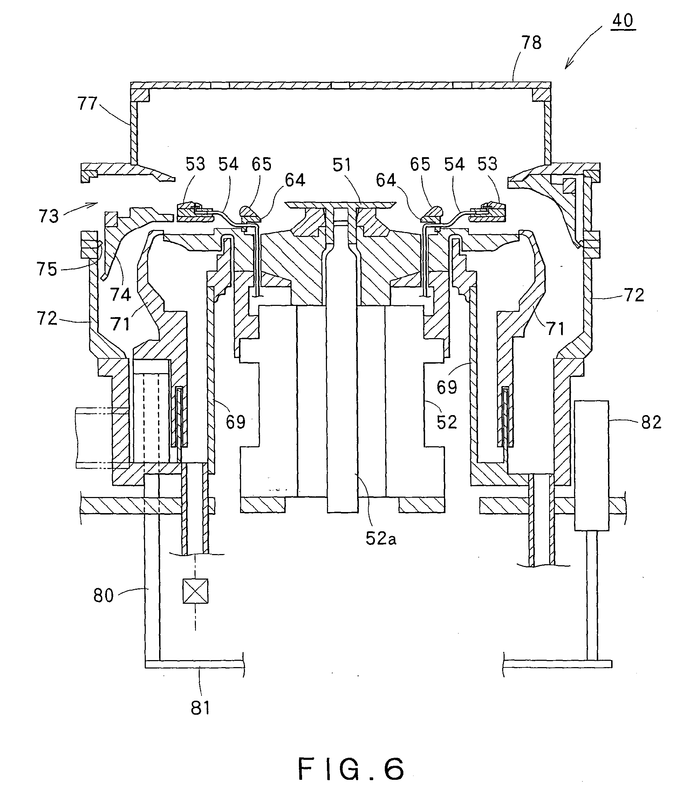

Next, the substrate cleaning apparatus 40 in one embodiment of the present invention is described with reference to Figs. 1 to 6. Fig. 1 is a schematic sectional view of a structure of a substrate cleaning apparatus of the present invention. Fig. 2 is a longitudinal sectional view taken along the arrow A-A of the substrate cleaning apparatus shown in Fig. 1. Fig. 3 is a longitudinal sectional view taken along the arrow B-B of the substrate cleaning apparatus shown in Fig. 1. Fig. 4 is a longitudinal sectional view taken along the arrow C-C of the substrate cleaning apparatus shown in Fig. 1. Fig. 5 is an enlarged view of a region D of the substrate cleaning apparatus shown in Fig. 2. Fig. 6 is a longitudinal sectional view of the substrate cleaning apparatus shown in Fig. 2 in which a wafer is not yet loaded into a cleaning tank.

As described above, a total of eight substrate cleaning apparatuses 40 are included in the substrate processing system 10. The substrate cleaning apparatuses 40 are substantially identical to each other. As shown in Fig. 1, each substrate cleaning apparatus 40 has a hermetically-sealable partition wall (unit chamber) 60 that separates this apparatus from other apparatuses. The partition wall 60 is provided with an opening 60a and a partition wall mechanical shutter 60b for opening/closing the opening 60a. In Figs. 2 to 6, the partition wall 60 is omitted.

As shown in Figs. 1 and 2, the substrate cleaning apparatus 40 includes a substantially cylindrical cleaning tank 70, a spin chuck (holding table) 51 rotatably disposed in the cleaning tank 70 to hold a wafer W from a rear surface thereof, and a hollow motor (rotary drive part) 52 for rotating the spin chuck 51. Above the spin chuck 51, there is disposed a main nozzle 56 that supplies a chemical liquid, a deionized water (DIW), a nitrogen gas (N₂ gas) or the like onto a surface of a wafer W held by the spin chuck 51. The main nozzle 56 is fixed on a main nozzle arm 57 capable of swinging in a horizontal plane. A ring member (chemical liquid storing part) 53 is disposed at a position circumferentially outward of the spin chuck 51, for storing a chemical liquid along a peripheral part of the wafer W held by the spin chuck 51, so as to immerse the peripheral part of the wafer W in the chemical liquid. A chemical liquid supply pipe (chemical liquid supply part) 54 that supplies a chemical liquid to the ring member 53 is connected to the ring member 53. As shown in Figs. 1 to 4, a brushing mechanism 55 is disposed at a position circumferentially outward of the spin chuck 51, for brushing the peripheral part of the wafer W held by the spin chuck 51.
The respective constituent elements of the substrate cleaning apparatus 40 are described in detail below.

As shown in Fig. 1, the substantially cylindrical cleaning tank 70 is disposed inside the partition wall 60. At first, a structure of the cleaning tank 70 is concretely described.
As shown in Figs. 2 and 6, the cleaning tank 70 includes a substantially cylindrical inner cup 71 capable of vertically moving relative to the spin chuck 51 so as to selectively surround the spin chuck 51, and a substantially cylindrical outer chamber 72 disposed to surround the inner cup 71. An opening 73 through which a wafer W is loaded and unloaded is formed in the outer chamber 72 at a position opposing to the opening 60a in the partition wall 60. A shutter 74 for opening and closing the opening 73 is disposed on the opening 73. The shutter 74 is formed into an annular shape, and has on its inner surface an inclined surface 74a whose diameter is downwardly enlarged for receiving chemical liquid droplets scattered around a wafer W. The shutter 74 is vertically moved by a not-shown opening/closing mechanism, such as a cylinder, to slide along a sealing member 75 circumferentially disposed on an inner wall surface of the outer chamber 72. In a closed condition, the shutter 74 is configured to be in contact with the outer chamber 72 through an O-ring 76. When the opening 73 is closed by the shutter 74, an atmosphere in the outer chamber 72 is prevented from leaking outside through the opening 73.

A cylindrical upper sidewall 77 is formed above the outer chamber 72. An opening 77a for nozzle through which the main nozzle arm 57 passes is formed in the upper sidewall 77 at a position substantially opposed to the opening 73.
An upper end of the upper sidewall 77 is closed by a ceiling 78. A plurality of, e.g., five inlet ports 78a for introducing a downflow fluid DF, such as an N₂ gas (nitrogen gas) or a clean air, are formed in the ceiling 78 such that one of the inlet ports 78a is positioned at a center of the ceiling 78 and the rest inlet ports 78a are positioned to surround the center inlet port 78a.

As shown in Fig. 2, under the state that the inner cup 71 is raised so that a wafer W is surrounded by a sidewall 71d of the inner cup 71, a downflow fluid flows from above the wafer W into a gap between a motor enclosing cylindrical member 69 (described below) and the sidewall 71d, and the fluid is discharged through an inner cup outlet channel 71c disposed on a lower part of the inner cup 71. On the other hand, under the state that the inner cup 71 is lowered so that the wafer w is surrounded by the outer chamber 72, the downflow fluid flows from above the wafer W into a gap between the motor enclosing cylindrical member 69 and an inner surface 72a of the outer chamber 72, and the fluid is discharged through an outer chamber outlet channel 72c.

As shown in Fig. 2, the outer chamber outlet channel 72c is disposed on a bottom part of the outer chamber 72. Owing to the outer chamber outlet channel 72c, the downflow fluid introduced from the inlet port 78a is discharged, and also liquid droplets in the outer chamber 72 are discharged.

The inner cup 71 is formed to surround the spin chuck 51, and is vertically movable between a raised position (see, Fig. 2) where the inner cup 71 surround a wafer W held on the spin chuck 51, and a lowered position (see, Fig. 6) where the inner cup 71 is lower than the wafer W. The inner cup 71 includes the substantially cylindrical sidewall 71d, and a bottom part 71e formed along a lower end of the sidewall 71d. As shown in Fig. 2, a connecting shaft 80 extended downward is connected to the inner cup 71. The connecting shaft 80 is connected to a horizontal member 81 which in turn is connected to an elevating cylinder 82. The inner cup 71 is moved upward and downward by the elevating cylinder 82 through the connecting shaft 80 and the horizontal member 81.

A circular opening 71f is formed in a central part of the bottom part 71e of the inner cup 71. The motor enclosing cylindrical member 69 is arranged inside the opening 71f. A chemical liquid or the like which is received by the inner cup 71 passes through the opening 71f to be discharged to a part below and inside the bottom part 71e. That is, an annular gap is formed between the inner surface of the inner cup 71 and an outer surface of the motor enclosing cylindrical member 69. Thus, a chemical liquid or the like received by the inner cup 71 passes through the gap to be discharged through the inner cup outlet channel 71c.

Next, the spin chuck (holding table) 51 for holding a wafer W from a rear surface thereof, and the hollow motor (rotary drive part) 52 for rotating the spin chuck 51 are concretely described.
The spin chuck 51 includes a holding plate 51a for holding a wafer W, and a rotating cylindrical member 51b connected to a lower part of the holding plate 51a. A lower end of the rotating cylindrical member 51b is connected to an upper end of a shaft 52a of the hollow motor 52. When the hollow motor 52 is driven, the shaft 52a is rotated so that the rotating cylindrical member 51b and the holding plate 51a are integrally rotated.

The holding plate 51a has one or more through-hole(s). A sucking device (not shown) communicated with the through-hole(s) is disposed below the holding plate 51a. When a wafer W is placed on the holding plate 51a, the sucking device performs a sucking action, whereby the wafer W is absorbed by the holding plate 51a and held thereon.
As shown in Fig. 2, the hollow motor 52 is housed in a hollow portion of the motor enclosing cylindrical member 69.

Next, the main nozzle 56 for supplying a chemical liquid or the like onto a surface of a wafer W held by the spin chuck 51, and the main nozzle arm 57 supporting the main nozzle 56 are concretely described.
The main nozzle 56 has a function of supplying a chemical liquid, a deionized water (DIW), a nitrogen gas (N₂ gas) or the like onto a surface of a wafer W held by the spin chuck 51. In the main nozzle arm 57 supporting the main nozzle 56, there is provided a fluid supply path 59 for a chemical liquid and an N₂ gas (see, Fig. 1). The fluid supply path 56 is opened to the main nozzle 56 mounted on a distal end of the main nozzle arm 57. A proximal end of the main nozzle arm 57 is connected to a rotary drive mechanism 61 disposed outside the cleaning tank 70. The main nozzle arm 57 is driven by the rotary drive mechanism 61 to rotate about the proximal end in a horizontal plane. Thus, the main nozzle 56 is moved from a retracted position outside the outer chamber 72 to a position above a central part of a wafer W through the nozzle opening 77a, and is moved from the position above the central part of the wafer W to the retracted position outside the outer chamber 72. Thus, the main nozzle 56 is capable of moving at least the position above a central part of a wafer W to a position above a peripheral part of the wafer W.

In the substrate cleaning apparatus 40 in this embodiment, as shown in Figs. 1, 2, and 5, the ring member 53 for storing a chemical liquid is disposed at a position circumferentially outward of the spin chuck 51, for storing a chemical liquid along a peripheral part of the wafer W held by the spin chuck 51. A wafer W held by the spin chuck 51 is immersed in the chemical liquid stored in the ring member 53. A plurality of, e.g., eight chemical liquid supply pipes 54 are connected to the ring member 53.

As shown in Fig. 1, the ring member 53 is formed into an annular shape excluding a cutout region 53p to surround a peripheral part of a wafer W. In other words, the ring member 53 is formed into a so-called C-shape when seen from above the cleaning tank 70.
Fig. 5 shows a detailed structure of the ring member 53. Fig. 5 is an enlarged view of a region D of the substrate cleaning apparatus shown in Fig. 2.

As shown in Fig. 5, the ring member 53 includes a substantially annular base member 53a (having a C-shape when seen from above), a substantially annular body member 53b fixed on an upper surface of the base member 53a, and a substantially annular storing member 53c disposed on an upper surface of the body member 53b. Positions of the base member 53a and the body member 53b are secured relative to the cleaning tank 70. On the other hand, the storing member 53c is detachable from the body member 53b, and thus the storing member 53c suitable for a size and a thickness of a wafer W can be variously fixed on the body member 53b. By replacing the storing members 53c, an amount of a chemical liquid stored in the storing member 53c can be adjusted.
As shown in Fig. 5, the body member 53b includes a chemical liquid supply path 53d which is communicated with the chemical liquid supply pipe 54 and is opened upward. The storing member 53c includes a chemical liquid supply path 53e which is communicated with the chemical liquid supply path 53d and is opened upward. A chemical liquid sent from the chemical liquid supply pipe 54 is sent to an upper surface of the storing member 53c through the chemical liquid supply path 53d and the chemical liquid supply path 53e. In the upper surface of the storing member 53c, the chemical liquid is stored in a condition indicated by the reference character M in Fig. 5.
As shown in Fig. 5, the opening of the chemical liquid supply path 53e in the upper surface of the storing member 53c is located at a position below the wafer W and inside an inner periphery thereof in order that a chemical liquid is prevented from spattering a front surface (upper surface) of the wafer W

In Fig. 5, a rear surface of the wafer W and the upper surface of the body member 53b is vertically spaced apart from each other at, e.g., 6.5 mm. The chemical liquid supply path 53e in the storing member 53c is extended with a circular cross-section whose diameter is 1 mm. The rear surface of the wafer W and the upper surface of the storing member 53c (a position near an upper end of the chemical liquid supply path 53e) is vertically spaced apart from each other at, e.g., 1 mm. A part 53f of the storing member 53c is tapered to be upwardly enlarged, which is described in detail below.

One end of the chemical liquid supply pipe 54 is connected to the ring member 53, and the other end thereof is connected to a chemical liquid supply source 54a for supplying a chemical liquid such as a hydrofluoric acid (solution of hydrogen fluoride) to the ring member 53. An electromotive valve 54b is disposed on the chemical liquid supply pipe 54 near the chemical liquid supply source 54a. Opening and closing of the electromotive valve 54b is controlled by the below-described control computer 90, whereby a supply of a chemical liquid is controlled. The eight chemical liquid pipes 54 are disposed on one ring member 53. As shown in Fig. 1, the chemical liquid supply pipes 54 are connected to the ring member 53 at an interval equal to each other, avoiding the cutout region 53p.

As shown in Figs. 1 and 4, inside the cleaning tank 70, the brushing mechanism 55 for brushing a peripheral part of a wafer W held by the spin chuck 51 is disposed circumferentially outward of the spin chuck 51. The brushing mechanism 55 includes a shaft 55a fixed on a rotary drive mechanism 55e such as a motor and an actuator, a brush arm 55b, and an end part 55c. The brush arm 55b is rotatable about the shaft 55a. As shown in Fig. 4, a rotating brush 55d is connected to the end part 55c of the brushing mechanism 55 such that the rotating brush 55d is positioned at substantially the same level with a wafer W held by the spin chuck 51. A rotary controlling mechanism 55f such as a motor for rotating the rotating brush 55d is disposed on the end part 55c.

As shown in Fig. 1, the brush arm 55b can swing between a contact position in which the rotating brush 55d is in contact with a wafer W held by the spin chuck 51, and a retracted position in which the rotating brush 55d is spaced apart from the wafer W (see, the arrow in Fig. 1). When the rotating brush 55d comes into contact with the peripheral part of the wafer W, the rotating brush 55d enters the cutout region 53p of the ring member 53, so that the rotating brush 55d does not contact the ring member 53. Fig. 4 shows that the rotating brush 55d is located in the contact position in which the rotating brush 55d is in contact with the peripheral part of the wafer W held by the spin chuck 51. Under this state, the wafer W itself is rotated, and the rotating brush 55d is rotated by the rotary drive mechanism 55f to rotate 360-degree one time per second, for example, so as to brush the peripheral part of the wafer W.

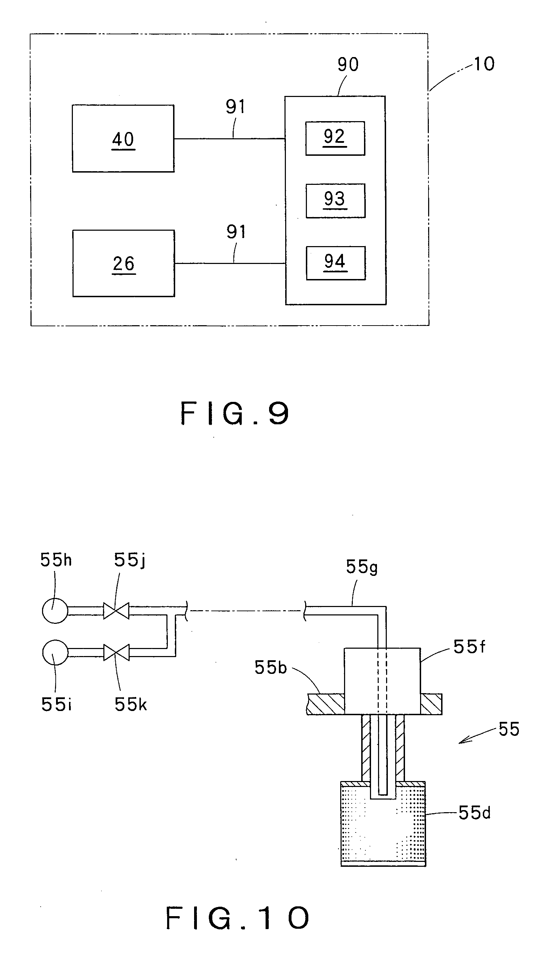

At this time, the rotating brush 55d may supply a chemical liquid or a deionized water onto the peripheral part of the wafer W. In this case, the rotating brush 55d is formed of a resin material having a number of small holes. To be specific, as shown in Fig. 10, a supply pipe 55g whose one end is connected to the rotating brush 55d passes through a hollow rotating motor 55f and a rotating shaft (hollow shaft), and the other end of the supply pipe 55g is diverged into two which are connected to a chemical liquid supply source 55h and a deionized liquid supply source 55i. Electromotive valves 55j and 55k are disposed near the chemical liquid supply source 55h and the deionized water supply source 55i, respectively. Opening and closing of the respective electromotive valves 55j and 55k are controlled by the below-described control computer 90.

As shown in Figs. 2 and 5, a first nozzle 62 is disposed above the ring member 53. More specifically, the first nozzle 62 includes a chemical liquid nozzle 62a, a cleaning water nozzle 62b, and an inert gas nozzle 62c. The chemical liquid nozzle 62a, the cleaning water nozzle 62b, and the inert gas nozzle 62c are arranged in this order, with the chemical liquid nozzle 62a being nearest to the peripheral part of the wafer W and the inert gas nozzle 62c being farthest away therefrom. The chemical liquid nozzle 62a is adapted to discharge a chemical liquid such as a hydrofluoric acid onto the peripheral part in the upper surface of the wafer W held by the spin chuck 51. The inert gas nozzle 62c discharges an inert gas such as an N₂ gas onto the peripheral part on the upper surface of the wafer W, so as to form an airflow flowing radially outward in the upper surface of the wafer W, whereby a chemical liquid M stored in the storing member 53c is prevented from flowing radially inward (leftward in Fig. 5) in the upper surface of the wafer W. The cleaning water nozzle 62b is adapted to discharge a deionized water onto the peripheral part in the upper surface of the wafer W.
The part 53f of the surface of the storing member 53f is tapered to be upwardly enlarged. Thus, when a chemical liquid and a deionized water are discharged from the chemical liquid nozzle 62a and the cleaning water nozzle 62b, the chemical liquid and the deionized water spring back from the tapered surface 53f, so that the chemical liquid and the deionized water can be prevented from flowing radially outward (rightward in Fig. 5) along the storing member 53c.
As shown in Fig. 5, the chemical liquid nozzle 62a, the cleaning water nozzle 62b, and the inert gas nozzle 62c are connected to a chemical liquid supply source 62d, a cleaning water supply source 62e, and an inert gas supply source 62f, through respective supply pipes, respectively. Electromotive valves 62g, 62h, and 62i are disposed on the respective supply pipes. Opening and closing of the respective electromotive valves 62g, 62h, and 62i are controlled by the below-described control computer 90.

As shown in Fig. 2, the first nozzle 62 is supported by a first nozzle arm 63. The first nozzle 62 is can be moved by the first nozzle arm 63 between a position in which an end of the first nozzle 62 is adjacent to the peripheral part of the wafer W, and a position where the end of the first nozzle 62 is spaced apart form the peripheral part of the wafer W. The first nozzle arm 63 is connected to a driving mechanism which is capable of horizontally moving the first nozzle arm 63 to control a cleaning area in the front surface (upper surface) of the wafer W. The driving mechanism is adapted to move the end of the first nozzle 62 within an area indicated by the arrow E in Fig. 5, for example.

In place of the provision of the first nozzle 62 and the first nozzle arm 63, the main nozzle 56 may have a function similar to that of the first nozzle 62. That is to say, in place of disposing the first nozzle 62 and the first nozzle arm 63, the main nozzle arm 57 may be moved such that the main nozzle 56 is located at a position in which the main nozzle 56 is adjacent to the peripheral part of the wafer W, and the main nozzle 56 in this state may discharge an inert gas such as an N₂ gas, a deionized water, and a chemical liquid onto the peripheral part of the wafer W.

As shown in Figs. 1 and 3, a plurality of, e.g., four second nozzles 66 are disposed on the rear side of the wafer W held by the spin chuck 51. As shown in Fig. 1, the second nozzles 66 are disposed at an interval equal to each other. The second nozzles 66 are adapted to discharge a deionized water onto a part near the peripheral part in the rear surface of the wafer W held by the spin chuck 51. As shown in Fig. 3, the second nozzles 66 are connected to a deionized water supply source 66a through supply pipes. Each of the supply pipes are provided with an electromotive valve 66b, and opening and closing of the electromotive valve 66b are controlled by the below-described control computer 90.
As shown in Fig. 3, the second nozzles 66 are supported by an annular support ring 64 disposed below the wafer W and outward of the spin chuck 51. An annular shielding ring 65 is disposed on an upper surface of the support ring 64. An upper end of the shielding ring 65 is slightly spaced apart from the rear surface of the wafer W held by the spin chuck 51. To be specific, the upper end of the shielding ring 65 is spaced apart from at, e.g., 1 mm from the rear surface of the wafer W, so that a space between the rear surface of the wafer W held by the spin chuck 51 and the support ring 64 is substantially shielded (comparted). Due to the provision of the shielding ring 65, a chemical liquid and a deionized water used for cleaning the wafer W can be prevented from spreading radially inward in the rear surface of the wafer W to reach the spin chuck 51. Furthermore, particles generated by the driving operation of the hollow motor 52 can be prevented from diffusing radially outward from a position near the shaft 52a.

As shown in Fig. 9, the respective functional elements of the substrate cleaning apparatus 40 are connected through signal lines 91 to the control computer 90 for automatically controlling an operation of the substrate cleaning apparatus 40. The main wafer transfer apparatus 26 for loading/unloading a wafer W to/from the substrate cleaning apparatus 40 is also connected to the control computer 90, and the main wafer transfer apparatus 26 is controlled by the control computer 90. Herein, the respective functional elements mean all the elements which act to achieve a predetermined process condition, including, but not limited to, the hollow motor 52, the electromotive valve 54b for adjusting supply of a chemical liquid to the chemical liquid supply pipe 54, the rotary drive mechanisms 55e and 55f of the brushing mechanism 55, the fluid supply source (not shown) for sending a fluid to the fluid supply path 59, the opening/closing mechanism (not shown) of the partition wall mechanical shutter 60b, the rotary drive mechanism 61, the electromotive valves 62g, 62h, and 62i for adjusting supply of respective fluids to the respective nozzles 62a, 62b, and 62c of the first nozzle 62, the driving mechanism (not shown) of the first nozzle arm 63, the opening/closing mechanism (not shown) of the shutter 74, the electromotive valve 66b for adjusting supply of a deionized water to the second nozzle 66, the electromotive valves 55j and 55k for adjusting supply of a deionized water or a chemical liquid to the rotating brush 55d, and the elevating cylinder 82. The control computer 90 is typically a general-purpose computer capable of realizing an optional function depending on a program (software) to be executed.

The control computer 90 includes a central processing unit (CPU) 92, a circuit 93 for supporting the central processing unit 92, and a storage medium 94 storing a control program. By executing the control program, the control computer 90 controls the respective functional elements of the substrate cleaning apparatus 40 so as to realize various process conditions (a rotational speed of the spin chuck 51, a feed rate of a chemical liquid to the ring member 53, and so on) defined by predetermined process recipes.

The storage medium 94 may be fixedly mounted on the control computer 90. Alternatively, the storage medium 94 may removably mounted on a reader capable of reading the storage medium 94, which is disposed on the control computer 90. In the most typical embodiment, the storage medium 94 is formed of a hard disk drive in which a control software is installed by an operator of a manufacturing company of the substrate processing system 10. In another embodiment, the storage medium 94 is formed of a removable disk such as a CD-ROM or a DVD-ROM in which a control software is written. Such a removable disk is read by an optical reader disposed on the control computer 90. The storage medium 94 may either be a RAM (random access memory) type or ROM (read only memory) type. Alternatively, the storage medium 94 may be a cassette type ROM or a memory card. In short, any medium known in the technical field of a computer can be employed as the storage medium 94. A program stored in the storage medium 94 controls the substrate cleaning apparatus 40 to executed a cleaning method of a wafer W described in detail below.

Next, a method of cleaning a wafer W carried out by the substrate cleaning apparatus 40 as structured above is described.
At first, before a wafer W is sent to the substrate cleaning apparatus 40, the wafer W is etched by the etching apparatus 32a or 32b.
To be specific, as described above, the wafer W is conveyed from the second transfer unit 28 to the third transfer unit 30, and the wafer W is brought into the etching apparatus 32a or 32b from the third transfer unit 30. The wafer W, which has been brought into the etching apparatus 32a or 32b, is subjected to an etching process in the etching apparatus 32a or 32b.
The etched wafer W is again brought out to the third transfer unit 30. The wafer W is then received by the second wafer transfer apparatus 28, and is transferred to the second transfer unit 24. Thereafter, the wafer W is received by the main wafer transfer apparatus 26, and is brought into the substrate cleaning apparatus 40 by the main wafer transfer apparatus 26.

In a state where the wafer W is not yet loaded into the substrate cleaning apparatus 40, as shown in Fig. 6, the inner cup 71 is previously lowered and an upper part of the spin chuck 51 is projected from above the inner cup 71. The shutter 74 is lowered to open the opening 73 in the outer chamber 72. Under this state, the main nozzle arm 57 waits ready outside the nozzle opening 77a.

Under the state shown in Fig. 6, the wafer holding arm 27b of the main wafer transfer apparatus 26 holding the wafer W is allowed to enter the outer chamber 72 through the opening 60a in the partition wall 60 and the opening 73 in the outer chamber 72. Then, the wafer held by the wafer holding arm 27b is placed on the holding plate 51a of the spin chuck 51. Then, the sucking device arranged below the holding plate 51a performs a sucking action so as to absorb the wafer W onto the holding plate 51a. Thus, the wafer W is held on the holding plate 51a of the spin chuck 51.

After the wafer W is delivered to the spin chuck 51, the wafer holding arm 27b is moved backward from the spin chuck 51, and is retracted outside the outer chamber 72. After the wafer holding arm 27b is retracted, the opening 60a is closed by the shutter 60b. Then, the shutter 74 and the inner cup 71 are raised, so as to realize the state shown in Fig. 2.

Subsequently, the rotary drive mechanism 61 is driven to rotate the main nozzle arm 57 to allow the main nozzle 56 disposed on the distal end of the main nozzle arm 57 to enter the inner cup 71 through the nozzle opening 77a, and the main nozzle 56 is moved to a part above a central part of the wafer W. Then, the spin chuck 51 is driven by the hollow motor 52 to rotate at a low speed, so that the wafer W is rotated at a low speed together with the spin chuck 51. Following thereto, a chemical liquid is discharged from the main nozzle 56 to supply the same onto a part near the central part of an upper surface of the wafer W. The chemical liquid supplied onto the central part of the wafer W flows radially outward on the wafer W due to the centrifugal force caused by the rotation of the wafer W. In this manner, the surface of the wafer W is processed by the chemical liquid.

At least while the wafer W is being processed, a downflow gas is introduced from the inlet port 78a, so that a downflow DF is formed in the outer chamber 72.

Upon completion of the chemical liquid process to the surface of the wafer W, a deionized water is supplied from the main nozzle 56 so as to remove the chemical liquid. Then, supply of the deionized water is stopped, and a drying operation is carried out. At this time, an N₂ gas may be supplied from the main nozzle 56.

However, even when the chemical liquid process is performed to the wafer W, there is a possibility that the peripheral part of the wafer W cannot be thoroughly cleaned. That is to say, when the wafer W is subjected to the etching process by the etching apparatus 32a or 32b before the wafer W is sent to the substrate cleaning apparatus 40, a contamination such as a CFx polymer or the like adheres to the surface of the wafer W by the etching process. In this case, the CFx polymer or the like adhering to the peripheral part of the wafer W cannot be perfectly removed by means of the chemical liquid sent to the central part of the wafer W from the main nozzle 56. Therefore, the CFx polymer or the like adhering to the peripheral part of the wafer W has to be removed therefrom by the following method.

After the cleaning step for cleaning the overall surface of the wafer W by the main nozzle 56 is finished, a chemical liquid formed of a hydrofluoric acid, for example, is supplied to the substantially annular ring member 53 by the chemical liquid supply pipe 54. More specifically, as shown in Fig. 5, the chemical liquid M supplied from the chemical liquid supply pipe 54 is sent to a surface of the storing member 53c through the chemical liquid supply path 53d and the chemical liquid supply path 53e. Then, the chemical liquid M is stored in the storing member 53c by its surface tension itself, with being sandwiched between the surface of the storing member 53c and the peripheral part of the wafer W.

On the other hand, the first nozzle arm 63 is driven to move the discharge port of the first nozzle 62 disposed on the distal end of the first nozzle arm 63 to a position adjacent to the peripheral part of the wafer W. Then, an inert gas such as an N₂ gas is discharged from the inert gas nozzle 62c of the first nozzle 62. By means of an airflow formed by discharging the inert gas, the chemical liquid M sent to the surface of the storing member 53c can be prevented from flowing on the upper surface of the wafer W radially inward (toward the central part).
At this time, a chemical liquid such as a hydrofluoric acid is also discharged from the chemical liquid nozzle 62a of the first nozzle 62 toward the peripheral part of the wafer W. Thus, a cleaning area can be more sufficiently controlled. The chemical liquid nozzle 62a is disposed radially outward from the inert gas nozzle 62c. Thus, owing to the airflow of the inert gas discharged from the inert gas nozzle 62c, the chemical liquid supplied form the chemical liquid nozzle 62a is also prevented from flowing radially inward (toward the central part).

With the chemical liquid being stored in the substantially annular ring member 53, the spin chuck 51 is driven by the hollow motor 52 to rotate at a low speed, so that the wafer W is integrally rotated together with the spin chuck 51 at a low speed. While this operation is carried out, as shown in Fig. 5, the peripheral part of the wafer W is immersed in the chemical liquid for a long period of time. Since the contamination such as a CFx polymer or the like adhering to the peripheral part of the wafer W is immersed in the chemical liquid for a long period of time, the adhering force of the contamination to the wafer W is weakened, and thus the contamination floats up from the wafer W.

Then, simultaneously with the supply of the chemical liquid by the chemical liquid supply pipe 54 to the ring member 53, the brush arm 55b of the brushing mechanism 55 is rotated, and, as shown in Fig. 4, the rotating brush 55d disposed on the distal end of the brush arm 55b is brought into contact with the peripheral part of the wafer W. Then, the rotating brush 55d is rotated while the rotating brush 55d is being in contact with the peripheral part of the wafer W. At this time, a cleaning efficiency can be more enhanced by opening the electromotive valve 55j corresponding to the chemical liquid supply source 55h, so as to discharge a chemical liquid from the rotating brush 55d. In this manner, the contamination such as a CFx polymer or the like adhering to the peripheral part of the wafer W, which has been and immersed in the chemical liquid for a long period of time, is brushed and removed by the rotating brush 55d.

After the step of performing the chemical liquid process by sending the chemical liquid from the main nozzle 56 toward the central part of the surface of the wafer W, and the step of processing the peripheral part of the wafer W by immersing the same in the chemical liquid stored in the ring member 53, the inner cup 71 is lowered such that the wafer W is surrounded by the outer chamber 72.

After that, a deionized water is discharged from the cleaning water nozzle 62b of the first nozzle 62 toward the peripheral part on the front side of the wafer W, and an inert gas is discharged from the inert gas nozzle 62c. In addition, a deionized water is discharged from the second nozzles 66 toward a part near the peripheral part on the rear side of the wafer W. In this manner, the chemical liquid adhering to the wafer W is rinsed away by the deionized water.

At this time, the rotating brush 55d of the brushing mechanism 55 continues to be rotated while being in contact with the peripheral part of the wafer W. Simultaneously, since the electromotive 55k corresponding to the deionized supply source 55i is opened, a deionized water is supplied to the peripheral part of the wafer W from the rotating brush 55d. Thus, the contamination on the peripheral part of the wafer W can be more efficiently removed.
It is not necessary to use the rotating brush 55d of the brushing mechanism 55 both in the chemical liquid process and the rinsing process by a deionized water, and the rotating brush 55d may be used only in the chemical liquid process as described above. Alternatively, the rotating brush 55d may be in a retracted state in the chemical liquid process, and the rotating brush 55d may come into contact with the peripheral part of the wafer W so as to brush the same, only in the rinsing process by a deionized water. In either cases, by immersing the contamination such as CFx or the like adhering to the peripheral part of the wafer W in the chemical liquid so as to weaken the adhering force of the contamination to the wafer W, the contamination such as CFx or the like can be removed from the peripheral part of the wafer W by the brushing operation of the rotating brush 55d.

The deionized water supplied onto the wafer W is received by the outer chamber 72. The deionized water drops from a gap between the sidewall of the outer chamber 72 and the sidewall 71d of the inner cup 71 to a lower part of the outer chamber 72, and is discharged outside the substrate cleaning apparatus 40 through the outer chamber outlet channel 72c.

After the wafer W is sufficiently rinsed, supply of the deionized water from the first nozzle 62 and the second nozzles 66 is stopped. However, discharge of the inert gas such as an N₂ gas is continuously performed to dry the wafer W. In the drying process, the spin chuck 51 and the wafer W are rotated at a speed higher than that in the chemical liquid process.

After the wafer W is sufficiently dried, supply of the N₂ gas from the first nozzle 62 is stopped. Then, the first nozzle arm 63 is separated from the wafer W. Thereafter, driving of the hollow motor 52 is stopped so that rotation of the spin chuck 51 and the wafer W is stopped.

Subsequently, the shutter 74 is lowered to open the opening 73, and the wafer holding arm 27a of the main wafer transfer apparatus 26 is allowed to enter the outer chamber 72 through the opening 60a in the partition wall 60 and the opening 73 in the outer chamber 72. Then, the wafer W held on the spin chuck 51 is held by the wafer holding arm 27a reaching the spin chuck 51. In this manner, the wafer W is delivered from the spin chuck 51 to the wafer holding arm 27a. After the wafer W is held by the wafer holding arm 27a, the wafer holding arm 27a is retracted from the inside of the outer chamber 72, and the opening 73 is closed by the shutter 74. In this manner, the wafer W, which has been subjected to the cleaning process and the drying process, is unloaded from the substrate cleaning apparatus 40.

As described above, according to the substrate cleaning apparatus 40 in this embodiment, a chemical liquid is supplied by the chemical liquid supply pipe (chemical liquid supply part) 54 to the ring member (chemical liquid storing part) 53, and a peripheral part of a wafer W held by the spin chuck (holding table) 51 is immersed in the chemical liquid stored in the ring member 53. In addition, the peripheral part of the wafer W held by the spin chuck 51 is brushed by the rotating brush 55d. Thus, the peripheral part of the wafer W is immersed in the chemical liquid for a long period of time, which weakens the adhering force of the contamination adhering to the peripheral part of the wafer W relative to the wafer W. Since the contamination having the weakened adhering force relative to the wafer W is brushed by the rotating brush 55d, the contamination adhering to the peripheral part of the wafer W can be removed.

As described above, in place of the provision of the first nozzle 62 including the chemical liquid nozzle 62a, the cleaning water nozzle 62b, and the inert gas nozzle 62c, the main nozzle 56 may also have the function of the first nozzle 62. Namely, by adjusting a position of the main nozzle arm 57, the main nozzle 56 can be positioned at either of the central part of the wafer W and the peripheral part thereof. Thus, when the contamination on the peripheral part of the wafer W is removed, the main nozzle 56 may be moved to a position near the peripheral part of the wafer W and an inert gas and a chemical liquid may be discharged toward the peripheral part.

In this embodiment, although the substrate cleaning apparatus 40 and the etching apparatus 32 are arranged in one system, the substrate cleaning apparatus 40 may be used independently.

In addition, in the above description, the substrate cleaning apparatus 40 of the present invention is applied to a cleaning apparatus for a semiconductor wafer by way of an example. However, the present invention is not limited thereto. For example, the substrate is not limited to a semiconductor wafer, and may be a glass substrate for an LCD, a glass substrate, and so on.

## Claims

1. A substrate cleaning apparatus comprising:
a cleaning tank;
a holding table rotatably disposed in the cleaning tank, for holding a substrate to be processed;
a rotary drive unit for rotating the holding table;
a chemical liquid storing unit for storing a chemical liquid along a peripheral part of a substrate to be processed held by the holding table to immerse the peripheral part of the substrate to be processed in the chemical liquid;
a chemical liquid supply unit connected to the chemical liquid storing unit, for supplying the chemical liquid to the chemical liquid storing unit; and
a brush for brushing the peripheral part of the substrate to be processed held by the holding table.

2. The substrate cleaning apparatus according to claim 1, wherein
the chemical liquid supplied from the chemical liquid supply unit to the chemical liquid storing unit is a hydrofluoric acid.

3. The substrate cleaning apparatus according to claim 1, wherein
the brush brushes the peripheral part of the substrate to be processed, when a chemical liquid is supplied from the chemical liquid supply unit to the chemical liquid storing unit and the peripheral part of the substrate to be processed is immersed in the chemical liquid stored in the chemical liquid storing unit.

4. The substrate cleaning apparatus according to claim 1, wherein
the brush is capable of reciprocately moving between a contact position in which the brush is in contact with the peripheral part of the substrate to be processed held by the holding table, and a retracted position in which the brush is spaced aunit from the peripheral part, and
the peripheral part of the substrate to be processed rotated by the rotary drive unit is brushed by the brush, when the brush is in the contact position.

5. The substrate cleaning apparatus according to claim 1, wherein
a first nozzle is disposed above the chemical liquid storing unit, for discharging a gas onto the peripheral part in an upper surface of the substrate to be processed held by the holding table so as to form an airflow flowing radially outward on the upper surface of the substrate to be processed.

6. The substrate cleaning apparatus according to claim 5, wherein
the first nozzle is capable of further supplying water onto the peripheral part of the substrate to be processed held by the holding table.

7. The substrate cleaning apparatus according to claim 5, wherein
the first nozzle is capable of further supplying a chemical liquid onto the peripheral surface of the substrate to be processed held by the holding table.

8. The substrate cleaning apparatus according to claim 1, wherein
a second nozzle is disposed on a rear surface side of the substrate to be processed held by the holding table, for supplying water onto a part near the peripheral part of the substrate to be processed.

9. The substrate cleaning apparatus according to claim 1, wherein
the chemical liquid storing unit is formed into an annular shape excluding a cutout region to surround the peripheral part of the substrate to be processed, and the brush is disposed in the cutout region of the chemical liquid storing unit.

10. A substrate processing system comprising:
the substrate cleaning apparatus according to claim 1; and
an etching apparatus connected to the substrate cleaning apparatus, for etching a substrate to be processed.

11. A substrate cleaning method comprising the steps of:
holding a substrate to be processed by a holding table;
rotating the holding table;
storing a chemical liquid in a chemical liquid storing unit and immersing a peripheral part of the substrate to be processed in the chemical liquid; and
brushing the peripheral part of the substrate to be processed by a brush.

12. The substrate cleaning method according to claim 11, wherein
the brush brushes the peripheral part of the substrate to be processed, when the peripheral part of the substrate to be processed is immersed in the chemical liquid stored in the chemical liquid storing unit.

13. A storage medium storing a program that is executable by a control computer of a substrate cleaning apparatus, the storage medium controlling a substrate cleaning apparatus to perform a substrate cleaning method upon execution of the program, the substrate cleaning method comprising the steps of:
holding a substrate to be processed by a holding table;
rotating the holding table;
storing a chemical liquid in a chemical liquid storing unit and immersing a peripheral part of the substrate to be processed in the chemical liquid; and
brushing the peripheral part of the substrate to be processed by a brush.

14. The storage medium according to claim 13, wherein
the step of brushing the peripheral part of the substrate to be processed by a brush is performed when the peripheral part of the substrate to be processed is immersed in the chemical liquid stored in the chemical liquid storing unit.
